# EUROPEAN PATENT APPLICATION

(11) **EP 4 697 603 A1**
(43) Date of publication of application: **18.02.2026**
(21) Application number: 24306367.4
(22) Date of filing: 15.08.2024
(51) Int. Cl.: H03K 19/0175, H03K 19/0185

(54) **DUAL MODE I/O MODULE**

(71) Applicant: Molex, LLC, Lisle, IL 60532 (US)
(72) Inventor: VIEVILLE, Christophe, 27370 Saint Pierre Des Fleurs (FR); DROUET, Jean-Christophe, 76300 Sotteville-lés-Rouen (FR); GORY, Eric, 27400 Louviers (FR)
(74) Representative: Edson, Russell Gregory

(57) **Abstract**

A two terminal I/O module is provided. The I/O module can operate in a dual sourcing mode or a bipolar mode, using a single output circuit. The output circuit includes switches which determine whether one of the terminals is connected to a power supply or a ground depending on the mode.

## Description

### Field of Invention

The present disclosure relates to input/output (I/O) modules. In particular, the present disclosure relates to I/O modules for use in assembly lines.

### Background

I/O modules act as bridges between controller systems and external devices such as sensors and actuators. An I/O module may supply power to an external device via an output circuit. Some I/O modules may be configured to source power from two terminals ("dual sourcing" operation). Other I/O modules may be configured to source power from one terminal and sink power from another terminal ("bipolar" operation).

### Summary of Invention

The present invention provides a two terminal I/O module that can operate in a dual sourcing mode or a bipolar mode, using a single output circuit. The output circuit includes switches which determine whether one of the terminals is connected to a power supply or a ground depending on the mode.

According to an aspect of the present disclosure, there is provided an I/O module for an assembly line. The I/O module comprises a first terminal; a second terminal; and an output circuit comprising: a first switch connected to the first terminal; a second switch connected to the second terminal; a third switch connected to the second terminal; and a controller configured to: in a first mode, control the first switch and the second switch to connect the first terminal and the second terminal to a power supply via the first switch and the second switch respectively, and in a second mode, control the first switch to connect the first terminal to the power supply via the first switch and control the third switch to connect the second terminal to a ground via the third switch.

The controller may be configured to, in the first mode, control the third switch to isolate the second terminal from the ground.

The controller may be configured to, in the second mode, control the second switch to isolate the second terminal from the power supply.

The controller may be configured to provide a first driving signal to the first switch. In the first mode, the first driving signal may cause the first switch to close. In the second mode, the first driving signal may cause the first switch to close.

The I/O module may include a controller that comprises a first AND function connected to the second switch, an inverter function connected to an input of the first AND function, and a second AND function connected to the third switch. The second switch and the third switch may be controlled by the outputs of the first AND function and the second AND function, respectively. The controller may be configured to provide a configuration signal to the inverter function such that an inverted configuration signal is received by the first AND function. The configuration signal may define the first mode or the second mode. The controller may be configured to provide the configuration signal directly to the second AND function, and provide a second driving signal to the first AND function and the second AND function.

In the first mode, the combination of the inverted configuration signal and the second driving signal at the first AND function may generate an output that causes the second switch to close. In the second mode, the combination of the configuration signal and the second driving signal at the second AND function may generate an output that causes the third switch to close.

In the first mode, the combination of the configuration signal and the second driving signal at the second AND function may generate an output which causes the third switch to open.

In the second mode, the combination of the inverted configuration signal and the second driving signal at the first AND function may generate an output which causes the second switch to open.

One or more of the first switch, the second switch and the third switch may comprise a field-effect transistor (FET).

One or more of the first switch, the second switch and the third switch may comprise a metal-oxide-semiconductor field-effect transistor (MOSFET).

The first mode may be a dual sourcing mode in which the first terminal sources current from the power supply and the second terminal sources current from the power supply.

The second mode may be a bipolar mode in which the first terminal sources current from the power supply and the second terminal sinks current to the ground.

According to another aspect of the present disclosure, there is provided a system for an assembly line. The system comprises: an I/O module comprising a first terminal and a second terminal and being configured to be switchable between a first mode and a second mode; and a computer device comprising: a processor; a user interface; and a communicator. The user interface is configured to receive a selection of the first mode or the second mode for the I/O module, and the processor is configured to generate a signal defining the selected mode and transmit the signal to the I/O module via the communicator. The I/O module is configured to receive the signal from the computer device and: when the signal defines the first mode, connect the first terminal and the second terminal to a power supply, and when the signal defines the second mode, connect the first terminal to the power supply and connect the second terminal to a ground.

According to another aspect of the present disclosure, there is provided a method of controlling an I/O module for an assembly line. The I/O module comprises: a first terminal; a second terminal; and an output circuit comprising a first switch connected to the first terminal, a second switch connected to the second terminal, and a third switch connected to the second terminal. The method comprises: receiving a signal defining a first mode or a second mode for the I/O module; when the signal defines the first mode, controlling the first switch and the second switch so that the first terminal and the second terminal are connected to a power supply via the first switch and the second switch respectively; and when the signal defines the second mode, controlling the first switch and the third switch so that the first terminal is connected to a power supply via the first switch and the second terminal is connected to a ground via the third switch.

The method may further comprise: when the signal defines the first mode, controlling the third switch to isolate the second terminal from the ground.

The method may further comprise: when the signal defines the second mode, controlling the second switch to isolate the second terminal from the power supply.

The method may further comprise: when the signal defines the first mode, receiving a second signal defining the second mode; and controlling the first switch and the third switch so that the first terminal is connected to a power supply via the first switch and the second terminal is connected to a ground via the third switch.

The method may further comprise: when the signal defines the second mode, receiving a second signal defining the first mode; and controlling the first switch and the second switch so that the first terminal and the second terminal are connected to a power supply via the first switch and the second switch respectively.

According to another aspect of the present disclosure, there is provided a method of operating a system including an I/O module and a computer device which controls the I/O module. The I/O module comprises: a first terminal; a second terminal; and an output circuit comprising a first switch connected to the first terminal, a second switch connected to the second terminal, and a third switch connected to the second terminal. The method comprises: receiving, by the computer device, a selection of a mode for the I/O module; generating, by the computer device, a configuration signal defining the selected mode; receiving, by the I/O module, the configuration signal; when the configuration signal defines the first mode, controlling, by the I/O module, the first switch and the second switch so that the first terminal and the second terminal are connected to a power supply via the first switch and the second switch respectively; and when the configuration signal defines the second mode, controlling, by the I/O module, the first switch and the third switch so that the first terminal is connected to a power supply via the first switch and the second terminal is connected to a ground via the third switch.

The method may further comprise: when the configuration signal defines the first mode, receiving a second configuration signal defining the second mode; and controlling the first switch and the third switch so that the first terminal is connected to a power supply via the first switch and the second terminal is connected to a ground via the third switch.

The method may further comprise: when the configuration signal defines the second mode, receiving a second configuration signal defining the first mode; and controlling the first switch and the second switch so that the first terminal and the second terminal are connected to a power supply via the first switch and the second switch respectively.

### Brief Description of the Drawings

Further features and advantages of the present invention will become apparent from the following description of embodiments thereof, presented by way of example only, and by reference to the drawings, in which:
Figure 1 is a schematic diagram of a prior art dual sourcing output circuit;
Figure 2 is a schematic diagram of a prior art bipolar output circuit;
Figures 3A and 3B are schematic diagrams of a dual mode output circuit;
Figure 4 is a schematic diagram of a system including an I/O module and a computer device;
Figure 5 is a flow diagram showing a method of controlling an I/O module;
Figure 6 is a flow diagram showing a method of operating a system including an I/O module and a computer device.

### Detailed Description

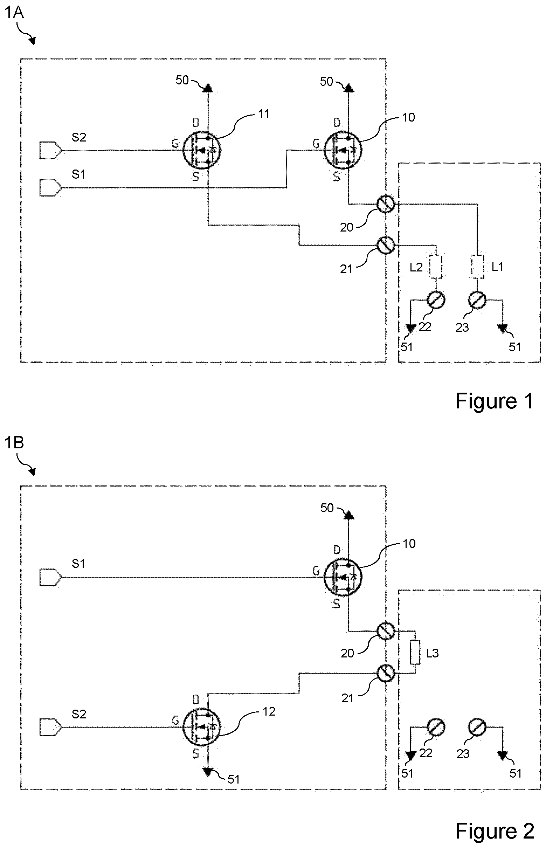

Figures 1 and 2 show examples of prior art output circuits for I/O modules (not shown).

Figure 1 shows an example of a prior art dual sourcing output circuit 1A. The output circuit 1A is connected to first and second terminals 20, 21. Loads L1 and L2 are connected between the first and second terminals 20, 21 and a ground 51 via first and second ground terminals 22, 23.

The dual sourcing output circuit 1A includes first and second switches 10, 11. The first and second switches 10, 11 may be, for example, field effect transistors (FETs) or intelligent high-side switches that source current flowing from a power supply 50 (which may be external to the I/O module) to the first and second loads L1, L2 connected to the first and second terminals 20, 21.

The first and second switches 10, 11 are controlled by first and second digital signals S1, S2 respectively. The first and second digital signals S1, S2 are generated by a processor (not shown). The first and second digital signals S1, S2 activate conduction of the first and second switches 10, 11 so that the first and second terminals 20, 21 source current.

Figure 2 shows an example of a prior art bipolar output circuit 1B. The output circuit 1B is connected to first and second terminals 20, 21. A load L3 is connected between the first and second terminals 20, 21.

The bipolar output circuit 1B includes first and second switches 10, 12. Current flows from a power supply 50 (which may be external to the I/O module) into the load L3 via the first switch 10, and then flows from the load to ground 51 through the second switch 12. The first switch 10 may be, for example, an FET or an intelligent high-side switch. The second switch 12 may be, for example, an FET or an intelligent low-side switch.

The first and second switches 10, 12 are controlled by first and second digital signals S1, S2 respectively. The first and second digital signals S1, S2 are generated by a processor (not shown). The first and second digital signals S1, S2 activate conduction of the first and second switches 10, 12 so that the first terminal 20 is connected to the power supply 50 and the second terminal 21 is connected to the ground 51.

In systems where it is desired to have both dual sourcing outputs and bipolar outputs, it is necessary to install two different I/O modules, a dual sourcing I/O module and a bipolar I/O module. The inventors have recognised that it would be beneficial to have a dual mode I/O module which can act as a dual sourcing module and a bipolar output module.

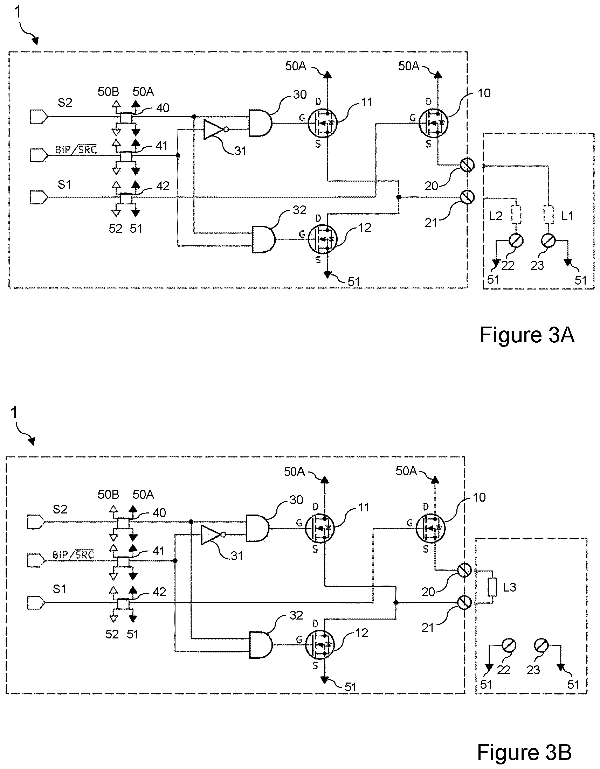

An example of an output circuit for dual mode I/O module is shown in Figures 3A and 3B. Figure 3A shows the output circuit in a dual sourcing mode, while Figure 3B shows the output circuit in a bipolar mode. The output circuit may be disposed in a housing of the I/O module (not shown).

The output circuit 1 is connected to a first terminal 20 and a second terminal 21 of the I/O module. The first terminal 20 can only source current, while the second terminal 21 can either source or sink current depending on whether the output circuit is in the dual sourcing mode or the bipolar mode.

The output circuit 1 includes a first switch 10, a second switch 11 and a third switch 12. While these switches are shown as n-type MOSFETs in the figures, it should be appreciated that the invention is not limited to this type of switch. Any other suitable type of switch may be used, such as bipolar transistors or relays.

The first terminal 20 is connected to the source of first switch 10. The drain of the first switch 10 may be connected to a power supply 50A, which may be external to the I/O module. The second terminal 21 is connected to a junction between the source of second switch 11 and the drain of third switch 12. The drain of the second switch 11 is connected to the power supply 50A, while the source of the third switch 12 is connected to a ground 51.

The output circuit 1 further includes a controller configured to control the operation of the switches 10, 11 12. The controller includes logic functions which are configured to prevent potential cross-conduction in the source/sink branch realized by the second and third switches 11, 12. While these logic functions are shown as logic gates in the figures, it should be appreciated that this is an illustration used to explain the operation of the controller, but the invention is not limited to this particular type of component. In other examples, the logic functions of the controller may be implemented using discrete transistors, programmable logic, firmware inside a microcontroller, or a combination of these.

In the example output circuit 1 shown in Figures 3A and 3B, a first AND gate 30 is connected to a gate of the second switch 11, so that the gate of the second switch is controlled by the output of the first AND gate 30. Similarly, a second AND gate 32 is connected to a gate of the third switch 12, so that the gate of the third switch 12 is controlled by the output of the second AND gate 32.

Several signals are used to control the operation of the switches 10, 11, 12. A first digital driving signal S1 is provided to the first switch 10, and a second digital driving signal S2 is provided to the second and third switches 11, 12 via the first and second AND gates 30, 32. A configuration signal BIP/SRC is provided directly to a second input of the second AND gate 32. The configuration signal BIP/SRC is inverted through an inverter function 31, and the inverted configuration signal is provided to a second input of the first AND gate 30.

In the configuration shown in Figure 3A, a first load L1 is connected between the first terminal 20 and ground 51, and a second load L2 is connected between the second terminal 21 and ground 51. The configuration signal BIP/SRC is set low, and the output of the second AND gate 32 will be low whatever the state of the second driving signal S2, so that the third switch 12 remains nonconducting. The output of the first AND gate 30 follows the state of the second driving signal S2, causing the second switch 11 to be consequently driven by the second driving signal S2. In the present case, the second driving signal S2 is set high so that the second switch 11 is turned on and connects the second terminal 21 to the power supply 50A. The first driving signal S1 is also set high, so that the first switch 10 is also turned on causing the first terminal 20 to be connected to the power supply 50A. Current is thus supplied to the loads L1, L2 from both the first and second terminals 20, 21 and the output circuit 1 operates in dual sourcing mode.

In the configuration shown in Figure 3B, a third load L3 is connected between first and second terminals 20, 21. The configuration signal BIP/SRC is set high, and the output of the first AND gate 30 will be low whatever the state of the second driving signal S2, so that the second switch 11 remains non-conducting. The output of the second AND gate 32 follows the state of the second driving signal S2, causing the third switch 12 to be consequently driven by the second driving signal S2. In the present case, the first driving signal S1 is set high so that the first switch is turned on and connects the first terminal 20 to the power supply 50A. The second driving signal S2 is also set high, so that the third switch 12 is also turned on causing the second terminal 21 to be connected to the ground 51. Current flows from the first terminal 20 through the third load L3 to the ground 51, so that the output circuit 1 operates in bipolar mode.

Industrial I/O modules are usually powered from two separate power supplies. In the present case, the power supply 50A (referred to as an "output power supply") can be externally switched off to de-energize all devices connected to the I/O module. A second power supply 50B (referred to as a "logic power supply") is provided which supplies current to the logic gates and network circuits. This permits continued communication between a controller system and the I/O module even if the output power supply 50A is switched off. The logic power supply 50B is used to generate the first and second driving signals S1, S2 and the configuration signal BIP/SRC. The logic power supply 50B has its negative terminal connected to terminal 52.

It may be desirable to completely isolate the output power supply 50A and the logic power supply 50B from each other, so that even the negative terminals of the power supplies 50A, 50B are isolated. Therefore, in the present example, first, second and third isolator devices 40, 41, 42 are connected between the signal sources and the switches 10, 11, 12 to transfer the signal information from the "logic power supply" domain to the "output power supply" domain which includes the switches 10, 11, 12. Each isolator device 40, 41, 42 is connected to the output power supply 50A and the logic power supply 50B, as well as the ground 51 and the terminal 52. For clarity, Figures 3A and 3B only show labels for the connections of the first isolator device 40 to the power supplies 50A, 50B, and for the connections of the third isolator device 42 to the ground 51 and terminal 52.

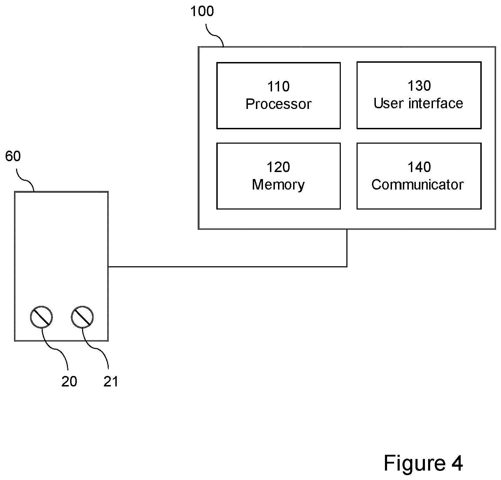

Figure 4 shows an example of a system including an I/O module and a computer device which controls the I/O module. The system may be implemented in an assembly line.

The I/O module 60 is switchable between a dual sourcing mode and a bipolar mode, and includes an output circuit including a first terminal 20 and a second terminal 21. The output circuit may be as shown above in relation to Figures 3A and 3B.

In the present example, the computer device 100 is a programmable logic controller (PLC). The PLC 100 includes a processor 110 configured to generate signals for controlling the I/O module 60. The PLC 100 also includes a memory 120.

The PLC 100 further includes a user interface 130 which is configured to receive a selection of the dual sourcing mode or the bipolar mode for the I/O module 60. In the present example, the user interface 130 includes a display which displays a graphical user interface (GUI) including selectable elements which correspond to the different modes. The GUI is generated by software stored in the memory 120.

When the user interface receives a selection of an element corresponding to a particular mode for the I/O module 60, the processor 110 generates a configuration signal defining the selected mode, and sends the configuration signal to the I/O module 60 via communicator 140. The configuration signal may be the configuration signal BIP/SRC discussed above in relation to Figures 3A and 3B. The communicator 140 may communicate with the I/O module 60 over a local area network (LAN), such as a wired or wireless LAN. In other examples, the communicator 140 may communicate with the I/O module 60 over the Internet.

The processor 110 may also generate driving signals for driving the output circuit of the I/O module 60. For example, the processor 110 may generate the driving signals S1 and S2 discussed above in relation to Figures 3A and 3B. The processor 110 may send the driving signals to the I/O module 60 via the communicator 140.

In the present example, the I/O module 60 receives the configuration signal and the driving signals from the PLC 100 and, if the configuration signal defines the dual sourcing mode, connects the first terminal 20 and the second terminal 21 to a power supply (not shown). If the configuration signal defines the bipolar mode, the I/O module 60 connects the first terminal 20 to the power supply and connects the second terminal 21 to a ground (not shown).

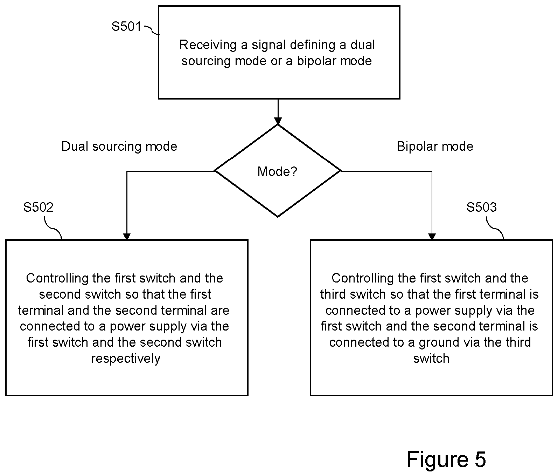

Figure 5 shows an example of a method of controlling an I/O module for an assembly line. The I/O module includes the output circuit 1 described above in relation to Figures 3A and 3B.

The method includes receiving a signal which defines a dual sourcing mode or a bipolar mode for the I/O module (S501). The signal may be received from a computer device which controls the I/O module, such as the computer device 100 described above in relation to Figure 4.

If the signal defines the dual sourcing mode, the first and second switches 10, 11 are controlled so that the first terminal 20 and the second terminal 21 are connected to a power supply via the first switch 10 and the second switch 11 respectively (S502). Current is thus supplied from both the first and second terminals 20, 21 to loads connected to the first and second terminals, and the I/O module operates in dual sourcing mode. The third switch 12 may be controlled to isolate the second terminal 21 from a ground.

If the signal defines the bipolar mode, the first switch 10 and the third switch 12 are controlled so that the first terminal 20 is connected to a power supply via the first switch 10 and the second terminal 21 is connected to a ground via the third switch 12 (S503). Current flows through a load connected between the first terminal 20 and the second terminal 21, so that the output circuit operates in bipolar mode. The second switch 11 may be controlled to isolate the second terminal 21 from the power supply.

The steps of the method shown in Figure 5 may be repeated, and the mode may be changed if a new signal is received which defines a mode which is different from the current mode. For example, the I/O module may be switched from the dual sourcing mode to the bipolar mode, or from the bipolar mode to the dual sourcing mode.

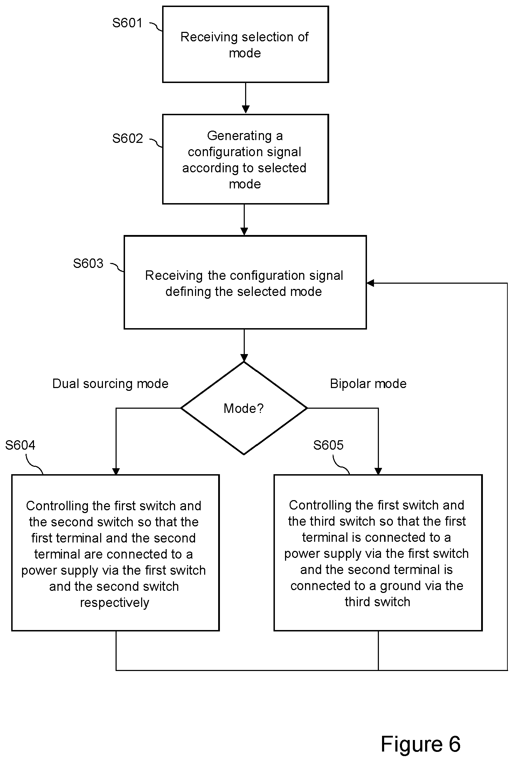

Figure 6 shows an example of a method of operating a system including an I/O module and a computer device which controls the I/O module. The system is as described above in relation to Figure 4.

The method includes receiving a selection of a particular mode for the I/O module (S601). This may be achieved by a user selecting an element on a GUI of the PLC. A configuration signal defining the selected mode is generated by the PLC (S602). The configuration signal may be the configuration signal BIP/SRC discussed above in relation to Figures 3A and 3B.

The configuration signal is received by the I/O module (S603). If the configuration signal defines the dual sourcing mode, the first and second switches 10, 11 are controlled so that the first terminal 20 and the second terminal 21 are connected to a power supply via the first switch 10 and the second switch 11 respectively (S604). If the configuration signal defines the bipolar mode, the first switch 10 and the third switch 12 are controlled so that the first terminal 20 is connected to a power supply via the first switch 10 and the second terminal 21 is connected to a ground via the third switch 12 (S605).

Once step S604 or S605 has been carried out, the method may return to step S603, and the mode may be changed if a new configuration signal is received which defines a mode which is different from the current mode. For example, the I/O module may be switched from the dual sourcing mode to the bipolar mode, or from the bipolar mode to the dual sourcing mode.

Various further modifications to the above described examples, whether by way of addition, deletion or substitution, will be apparent to the skilled person to provide additional examples, any and all of which are intended to be encompassed by the appended claims.

## Claims

1. An I/O module for an assembly line, the I/O module comprising:
a first terminal;
a second terminal; and
an output circuit comprising:
a first switch (10) connected to the first terminal (20);
a second switch (11) connected to the second terminal (21);
a third switch (12) connected to the second terminal; and
a controller configured to:
in a first mode, control the first switch and the second switch to connect the first terminal and the second terminal to a power supply via the first switch and the second switch respectively, and
in a second mode, control the first switch to connect the first terminal to the power supply via the first switch and control the third switch to connect the second terminal to a ground via the third switch.

2. The I/O module of claim 1, wherein the controller is configured to, in the first mode, control the third switch (12) to isolate the second terminal (21) from the ground.

3. The I/O module of claim 1 or 2, wherein the controller is configured to, in the second mode, control the second switch (11) to isolate the second terminal (21) from the power supply.

4. The I/O module of any one of the preceding claims, wherein the controller is configured to provide a first driving signal to the first switch,
wherein in the first mode, the first driving signal causes the first switch to close; and
wherein in the second mode, the first driving signal causes the first switch to close.

5. The I/O module of any one of the preceding claims, wherein the controller comprises:
a first AND function (30) connected to the second switch (11), wherein the second switch is controlled by the output of the first AND function;
an inverter function (31) connected to an input of the first AND function (30); and
a second AND function (32) connected to the third switch (12), wherein the third switch is controlled by the output of the second AND function;
wherein the controller is configured to:
provide a configuration signal to the inverter function such that an inverted configuration signal is received by the first AND function, wherein the configuration signal defines the first mode or the second mode,
provide the configuration signal directly to the second AND function, and
provide a second driving signal to the first AND function and the second AND function,
wherein in the first mode, the combination of the inverted configuration signal and the second driving signal at the first AND function generates an output which causes the second switch to close; and
wherein in the second mode, the combination of the configuration signal and the second driving signal at the second AND function generates an output which causes the third switch to close.

6. The I/O module of claim 5, wherein, in the first mode, the combination of the configuration signal and the second driving signal at the second AND function generates an output which causes the third switch to open.

7. The I/O module of claim 5 or 6, wherein, in the second mode, the combination of the inverted configuration signal and the second driving signal at the first AND function generates an output which causes the second switch to open.

8. The I/O module of any one of the preceding claims, wherein one or more of the first switch, the second switch and the third switch comprises a field-effect transistor, FET.

9. The I/O module of claim 8, wherein one or more of the first switch, the second switch and the third switch comprises a metal-oxide-semiconductor field-effect transistor, MOSFET.

10. The I/O module of any one of the preceding claims, wherein, the first mode is a dual sourcing mode in which the first terminal sources current from the power supply and the second terminal sources current from the power supply.

11. The I/O module of any one of the preceding claims, wherein the second mode is a bipolar mode in which the first terminal sources current from the power supply and the second terminal sinks current to the ground.

12. A system for an assembly line, the system comprising:
an I/O module comprising a first terminal and a second terminal and being configured to be switchable between a first mode and a second mode; and
a computer device comprising:
a processor;
a user interface; and
a communicator;
wherein the user interface is configured to receive a selection of the first mode or the second mode for the I/O module, and
wherein the processor is configured to generate a signal defining the selected mode and transmit the signal to the I/O module via the communicator,
wherein the I/O module is configured to receive the signal from the computer device and:
when the signal defines the first mode, connect the first terminal and the second terminal to a power supply, and
when the signal defines the second mode, connect the first terminal to the power supply and connect the second terminal to a ground.

13. A method of controlling an I/O module for an assembly line, the I/O module comprising: a first terminal; a second terminal; and an output circuit comprising a first switch connected to the first terminal, a second switch connected to the second terminal, and a third switch connected to the second terminal, the method comprising:
receiving a signal defining a first mode or a second mode for the I/O module;
when the signal defines the first mode, controlling the first switch and the second switch so that the first terminal and the second terminal are connected to a power supply via the first switch and the second switch respectively; and
when the signal defines the second mode, controlling the first switch and the third switch so that the first terminal is connected to the power supply via the first switch and the second terminal is connected to a ground via the third switch.

14. The method of claim 13, further comprising:
when the signal defines the first mode, controlling the third switch to isolate the second terminal from the ground.

15. The method of claim 13 or 14, further comprising:
when the signal defines the second mode, controlling the second switch to isolate the second terminal from the power supply.

## Amended claims

### Amended claims in accordance with Rule 137(2) EPC.

1. An I/O module for an assembly line, the I/O module comprising:
a first terminal;
a second terminal; and
an output circuit comprising:
a first switch (10) connected to the first terminal (20);
a second switch (11) connected to the second terminal (21);
a third switch (12) connected to the second terminal; and
a controller configured to:
in a first, dual sourcing, mode in which the first terminal is arranged to source current from the power supply to a first load (L1) and the second terminal is arranged to source current from the power supply to a second load (L2), control the first switch and the second switch to connect the first terminal and the second terminal to the power supply via the first switch and the second switch respectively, and
in a second, bipolar, mode in which the first terminal is arranged to source current from the power supply to a third load (L3) connected between the first terminal and the second terminal and the second terminal is arranged to sink current from the load to the ground, control the first switch to connect the first terminal to the power supply via the first switch and control the third switch to connect the second terminal to the ground via the third switch.

2. The I/O module of claim 1, wherein the controller is configured to, in the dual sourcing mode, control the third switch (12) to isolate the second terminal (21) from the ground.

3. The I/O module of claim 1 or 2, wherein the controller is configured to, in the bipolar mode, control the second switch (11) to isolate the second terminal (21) from the power supply.

4. The I/O module of any one of the preceding claims, wherein the controller is configured to provide a first driving signal to the first switch,
wherein in the dual sourcing mode, the first driving signal causes the first switch to close; and
wherein in the bipolar mode, the first driving signal causes the first switch to close.

5. The I/O module of any one of the preceding claims, wherein the controller comprises:
a first AND function (30) connected to the second switch (11), wherein the second switch is controlled by the output of the first AND function;
an inverter function (31) connected to an input of the first AND function (30); and
a second AND function (32) connected to the third switch (12), wherein the third switch is controlled by the output of the second AND function;
wherein the controller is configured to:
provide a configuration signal to the inverter function such that an inverted configuration signal is received by the first AND function, wherein the configuration signal defines the dual sourcing mode or the bipolar mode,
provide the configuration signal directly to the second AND function, and
provide a second driving signal to the first AND function and the second AND function,
wherein in the dual sourcing mode, the combination of the inverted configuration signal and the second driving signal at the first AND function generates an output which causes the second switch to close; and
wherein in the bipolar mode, the combination of the configuration signal and the second driving signal at the second AND function generates an output which causes the third switch to close.

6. The I/O module of claim 5, wherein, in the dual sourcing mode, the combination of the configuration signal and the second driving signal at the second AND function generates an output which causes the third switch to open.

7. The I/O module of claim 5 or 6, wherein, in the bipolar mode, the combination of the inverted configuration signal and the second driving signal at the first AND function generates an output which causes the second switch to open.

8. The I/O module of any one of the preceding claims, wherein one or more of the first switch, the second switch and the third switch comprises a field-effect transistor, FET.

9. The I/O module of claim 8, wherein one or more of the first switch, the second switch and the third switch comprises a metal-oxide-semiconductor field-effect transistor, MOSFET.

10. A system for an assembly line, the system comprising:
an I/O module according to any one of the preceding claims; and
a computer device comprising:
a processor;
a user interface; and
a communicator;
wherein the user interface is configured to receive a selection of the dual sourcing mode or the bipolar mode for the I/O module, and
wherein the processor is configured to generate a signal defining the selected mode and transmit the signal to the I/O module via the communicator,
wherein the I/O module is configured to receive the signal from the computer device and:
when the signal defines the dual sourcing mode, connect the first terminal and the second terminal to the power supply, and
when the signal defines the bipolar mode, connect the first terminal to the power supply and connect the second terminal to the ground.

11. A method of controlling an I/O module for an assembly line, the I/O module comprising: a first terminal; a second terminal; and an output circuit comprising a first switch connected to the first terminal, a second switch connected to the second terminal, and a third switch connected to the second terminal, the method comprising:
receiving a signal defining a first, dual sourcing, mode or a second, bipolar, mode for the I/O module;
when the signal defines the dual sourcing mode, controlling the first switch and the second switch so that the first terminal and the second terminal are connected to a power supply via the first switch and the second switch respectively, and the first terminal sources current from the power supply to a first load and the second terminal sources current from the power supply to a second load; and
when the signal defines the bipolar mode, controlling the first switch and the third switch so that the first terminal is connected to the power supply via the first switch and the second terminal is connected to a ground via the third switch, and the first terminal sources current from the power supply to a third load connected between the first terminal and the second terminal and the second terminal sinks current from the load to the ground.

12. The method of claim 11, further comprising:
when the signal defines the dual sourcing mode, controlling the third switch to isolate the second terminal from the ground.

13. The method of claim 11 or 12, further comprising:
when the signal defines the bipolar mode, controlling the second switch to isolate the second terminal from the power supply.
